# EUROPEAN PATENT SPECIFICATION

(11) **EP 3 076 445 B1**
(45) Date of publication and mention of the grant of the patent: **09.05.2018**
(21) Application number: 16163230.2
(22) Date of filing: 31.03.2016
(51) Int. Cl.: H01L 35/30, F24F 5/00, F25B 21/04

(54) **THERMOELECTRIC CONVERTER AND DEHUMIDIFIER USING THE SAME**
THERMOELEKTRISCHER WANDLER UND ENTFEUCHTER DAMIT
DÉSHUMIDIFICATEUR ET CONVERTISSEUR THERMOÉLECTRIQUE L'UTILISANT

(30) Priority: 31.03.2015 KR 20150045533
(43) Date of publication of application: 05.10.2016
(73) Proprietor: LG Innotek Co., Ltd., Seoul, 04637 (KR)
(72) Inventor: LEE, Jong Min, 04637 Seoul (KR); CHO, Yong Sang, 04637 Seoul (KR); WON, Boone, 04637 Seoul (KR)
(74) Representative: Zardi, Marco

(56) References cited:
- WO-A1-2015/163729
- JP-A- 2006 245 224
- JP-A- 2012 151 254
- US-A1- 2001 013 224

## Description

### BACKGROUND

### 1. Field of the Invention

Embodiments of the present invention relate to a device structure capable of improving cooling efficiency.

### 2. Discussion of Related Art

Dehumidification is a principle of removing moisture in the air using a condensation phenomenon in which moisture in the air is condensed to water using a temperature difference, and a device using this principle is a dehumidifier. Nowadays, in indoor spaces such as households or offices, in addition to demands on a humidifier that maintains humidity of a dry indoor space, demands on the dehumidifier that removes humidity of a damp indoor space to keep the indoor space pleasant is increasing.

So far, a cooling dehumidification method also referred to as a compressor method that dehumidifies by taking heat away and a heating dehumidification method also referred to as a desiccant method that dehumidifies using heat have been mainly used as methods of dehumidification.

Particularly, in case of the method using a compressor, since moisture in humid air is first condensed and discharged using a refrigerant and the air is dried again, a dehumidification effect depends on the capacity of the compressor, thus imposing a limitation in the dehumidification effect, and there is a major problem of an increase in noise due to excessive operation of the compressor for dehumidification up to capacity limit.

JP2012151254 describes a heat exchanger for an air conditioning unit using a Peltier module.

### SUMMARY OF THE INVENTION

Embodiments of the present invention are devised for resolving the problems mentioned above, and particularly, the present invention is directed to providing a thermoelectric converter implementing a structure in which two or more thermoelectric modules are stacked and cooling areas of the stacked thermoelectric modules are arranged in a compact structure to maximize cooling efficiency.

Particularly, a thermoelectric converter with enhanced cooling efficiency is applied to a dehumidifier to remove a compressor of a conventional compressor structure and to implement a dehumidifier only with a thermoelectric module having a structure that does not use chemical refrigerant at all.

A thermoelectric converter according to an embodiment of the present invention includes a first thermoelectric module including a first substrate, a second substrate disposed to face the first substrate, and a first thermoelectric element disposed between the first substrate and the second substrate; a first thermoelectric conversion member disposed on the first substrate; a second thermoelectric conversion member disposed on the second substrate; a second thermoelectric module including a third substrate, a fourth substrate disposed to face the third substrate, and a second thermoelectric element disposed between the third substrate and the fourth substrate; a third thermoelectric conversion member disposed on the third substrate; and a fourth thermoelectric conversion member disposed on the fourth substrate, wherein the first substrate and the third substrate may be heat generation substrates, the second substrate and the fourth substrate may be heat absorption substrates, and the first thermoelectric module and the second thermoelectric module may be arranged in a structure in which the second substrate and the fourth substrate face each other, wherein the first thermoelectric conversion member, the second thermoelectric conversion member, the third thermoelectric conversion member, and the fourth thermoelectric conversion member comprise a plurality of fin structures, wherein at least one of the first thermoelectric conversion member, the second thermoelectric conversion member, the third thermoelectric conversion member, and the fourth thermoelectric conversion member comprises:a heat generation base material having a first flat surface coming in contact with air and a second flat surface facing the first flat surface; at least one flow passage pattern structure configured to form an air flow passage within the heat generation base material in an air flowing direction;a plurality of fluid flowing grooves passing through the surfaces of the flow passage pattern; and a plurality of resistive pattern protruding from a surface of the heat generation base material on a surface of the flow passage pattern, wherein the fluid flowing grooves is arranged at connection parts of the resistive pattern and the flow passage pattern, wherein the resistive pattern is formed with a protruding structure tilted to have an inclined angle (Θ) in a direction in which the air enters, wherein the inclined angle is formed in a way that a horizontal extension line of the surface of the resistive pattern and an extension line of the surface of the flow passage pattern form an acute angle.

### BRIEF DESCRIPTION OF THE DRAWINGS

The above and other objects, features and advantages of the present invention will become more apparent to those of ordinary skill in the art by describing in detail exemplary embodiments thereof with reference to the accompanying drawings, in which:
FIG. 1 is a cross-sectional view of a thermoelectric converter according to an embodiment of the present invention;
FIG. 2 is an exploded perspective view of the thermoelectric converter illustrated in FIG. 1;
FIG. 3 illustrates an arrangement of thermoelectric conversion members sandwiching a first thermoelectric module at one portion of the structure of the thermoelectric converter illustrated in FIG. 1;
FIG. 4 is an enlarged perspective view exploded from a main portion of FIG. 3;
FIGS. 5 and 6 illustrate an embodiment of a structure of a thermoelectric conversion member according to FIGS. 3 and 4;
FIG. 7 illustrates an example of implementing a thermoelectric conversion module in a structure according to an embodiment different from the structure of the thermoelectric conversion member mentioned in FIG. 6;
FIGS. 8 and 9 are conceptual views illustrating a structure of a thermoelectric module applied to the thermoelectric converter according to the embodiment of the present invention;
FIG. 10 illustrates a modified embodiment in which a shape of the thermoelectric element mentioned in FIG. 9 is changed; and
FIGS. 11 to 13 are conceptual views illustrating another embodiment of a thermoelectric element applied to the thermoelectric converter according to the embodiment of the present invention.

### DETAILED DESCRIPTION OF EXEMPLARY EMBODIMENTS

Hereinafter, configurations and actions according to the present invention will be described in detail with reference to the accompanying drawings. In describing the present invention with reference to the accompanying drawings, like reference numerals will be given to like elements throughout the drawings and overlapping descriptions thereof will be omitted. Terms such as "first" and "second" may be used in describing various elements, but the elements should not be limited by the terms. The terms are used only for differentiating one element from another element.

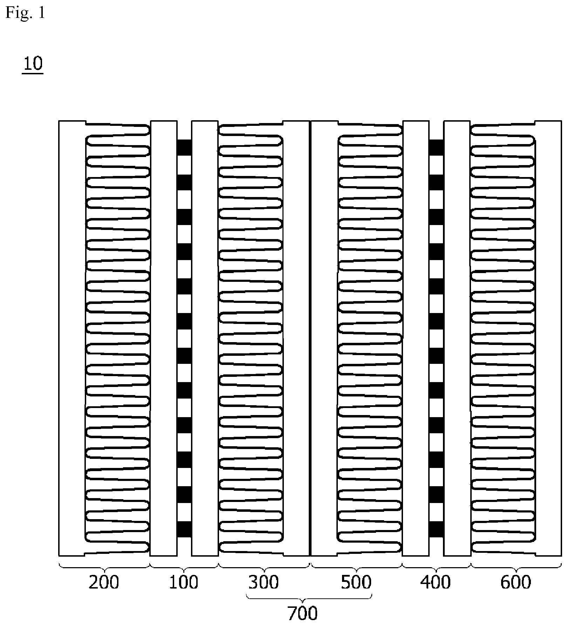

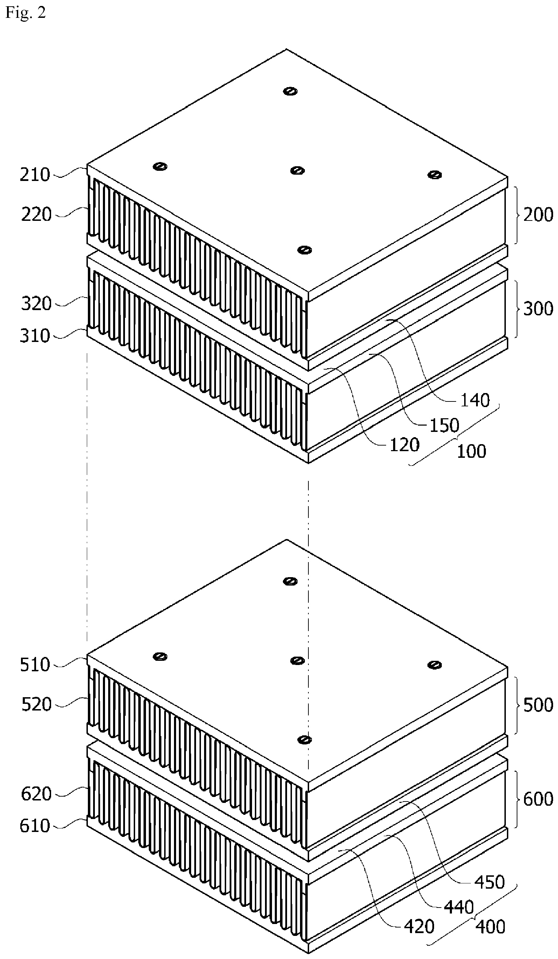

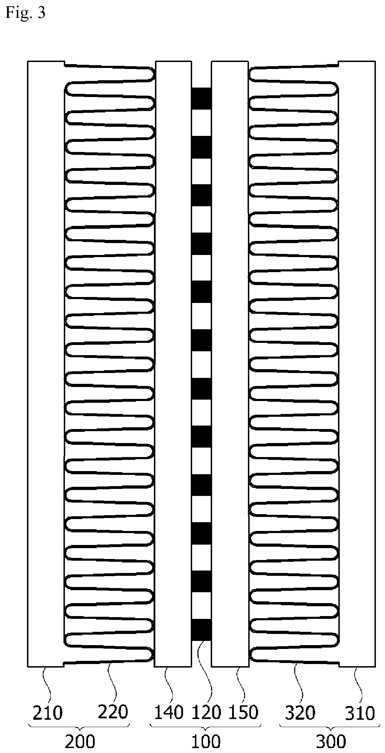

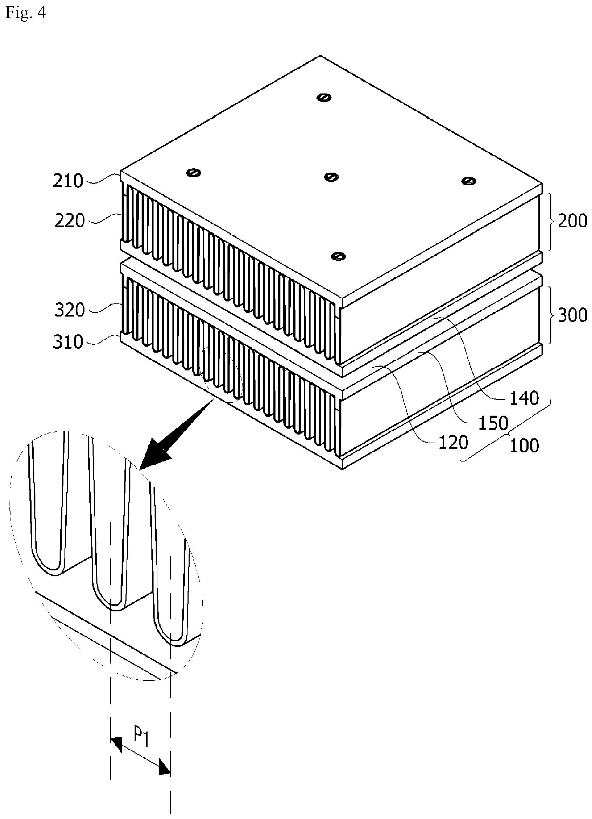

FIG. 1 is a cross-sectional view of a thermoelectric converter 10 according to an embodiment of the present invention. FIG. 2 is an exploded perspective view of the thermoelectric converter 10 illustrated in FIG. 1. FIG. 3 illustrates an arrangement of thermoelectric conversion members 220 and 320 sandwiching a first thermoelectric module 100 at one portion of the structure of the thermoelectric converter 10 illustrated in FIG. 1. FIG. 4 is an enlarged perspective view exploded from a main portion of FIG. 3.

Referring to FIGS. 1 and 2, the thermoelectric converter 10 according to the embodiment of the present invention includes the first thermoelectric module 100, a second thermoelectric module 400, a first thermoelectric conversion member 220, a second thermoelectric conversion member 320, a third thermoelectric conversion member 620, and a fourth thermoelectric conversion member 520.

The first thermoelectric module 100 may include a first substrate 140, a second substrate 150 disposed to face the first substrate 140, and a first thermoelectric element 120 disposed between the first substrate 140 and the second substrate 150. The first thermoelectric conversion member 220 may be disposed on the first substrate 140, and the second thermoelectric conversion member 320 may be disposed on the second substrate 150.

The second thermoelectric module 400 may include a third substrate 440, a fourth substrate 450 disposed to face the third substrate 440, and a second thermoelectric element 420 disposed between the third substrate 440 and the fourth substrate 450. The third thermoelectric conversion member 620 may be disposed on the third substrate 440, and the fourth thermoelectric conversion member 520 may be disposed on the fourth substrate 450.

The first substrate 140 and the third substrate 440 may be heat generation substrates implementing heat generation areas, and the second substrate 150 and the fourth substrate 450 may be heat absorption substrates implementing heat absorption areas.

The second substrate 150 and the fourth substrate 450 may be arranged in a structure facing each other.

In the embodiment of the present invention, the one pair of thermoelectric modules 100 and 400 is disposed in a structure in which the thermoelectric conversion members 320 and 520 implementing a cold sink function are shared in an area implementing a cooling area 700 among thermoelectric conversion modules 200, 300, 500, and 600 including the thermoelectric conversion members 220, 320, 520, and 620, respectively, as parts functioning as a heat sink or a cold sink implementing a thermoelectric conversion action disposed at each of the thermoelectric modules, thereby maximizing cooling efficiency. That is, the second thermoelectric conversion module 300 and the fourth thermoelectric conversion module 500 respectively including the second thermoelectric conversion member 320 and the fourth thermoelectric conversion member 520 that perform a heat absorption function may come in close contact with each other at a portion of the cooling area 700.

The first thermoelectric module 100 has a structure in which the first thermoelectric element 120 which is mutually electrically connecting is disposed between the one pair of substrates 140 and 150. A P-type semiconductor and an N-type semiconductor are disposed as a pair at the first thermoelectric element 120, and when current is applied, a heat absorption part and a heat generation part are respectively implemented at the above-mentioned pair of substrates 140 and 150 due to the Peltier effect. In the embodiment of the present invention, a case in which a heat absorption (cooling) area is formed close to the second substrate 150 and a heat generation area is formed close to the first substrate 140 in the structure of FIG. 1 will be described as an example. Here, of course in the case of the second thermoelectric module 400, a heat absorption (cooling) area may be formed close to the fourth thermoelectric conversion member 520 disposed at an upper portion of the fourth substrate 450, and then a heat generation area may be formed close to the third thermoelectric conversion member 620 disposed close to the third substrate 440.

Accordingly, in the embodiment of the present invention, the second thermoelectric conversion module 300 and the fourth thermoelectric conversion module 500 respectively including the thermoelectric conversion members 320 and 520 that respectively form cooling areas of the first thermoelectric module 100 and the second thermoelectric module 400 are arranged in a compact structure at an area defined as the cooling area 700, thereby further maximizing the cooling efficiency by concentrating cooling effects of the two thermoelectric modules to one area.

In this case, outside air introduced into the cooling area 700 which is a central portion performs a cooling process, and the first thermoelectric conversion module 200 and the third thermoelectric conversion module 600 arranged at the heat generation areas of the first thermoelectric module 100 and the second thermoelectric module 400 arranged outside simultaneously perform a drying function, thereby efficiently drying and removing moisture contained in the air. This structure enables a small-capacity dehumidification action that allows performing dehumidification and drying to a desired temperature even without structures such as a cooler using refrigerant and a compressor compressing the refrigerant in a conventional dehumidifier.

FIGS. 3 and 4 are views illustrating structures of the first thermoelectric conversion module 200 and the second thermoelectric conversion module 300 sandwiching the first thermoelectric module 100 of the thermoelectric converter 10 according to the embodiment of the present invention. With reference to FIGS. 3 and 4, the structures of the first thermoelectric conversion module 200 and the second thermoelectric conversion module 300 of the thermoelectric converter 10 according to the embodiment of the present invention may include a thermoelectric conversion member having a predetermined pitch P1 and capable of implementing a cooling or heat generation effect implemented by the first substrate 140 and the second substrate 150 coming in contact with air.

Referring to FIGS. 3 and 4, the thermoelectric conversion members 220 and 320 may be formed in a structure in which each is arranged within separate accommodation modules 210 and 310. The thermoelectric conversion modules 200 and 300 are respectively disposed on the one pair of the first substrate 140 and the second substrate 150. In the illustrated structure, the thermoelectric conversion members 220 and 320 may be implemented in a structure in which each comes directly in contact with surfaces of the first substrate 140 and the second substrate 150, respectively, or a structure in which each comes indirectly in contact therewith via the separate accommodation modules 210 and 310. In the thermoelectric converter 10 according to the present invention, the structures of the thermoelectric conversion members 220 and 320 that respectively come in contact with the first substrate 140 and the second substrate 150 to perform thermal conversion may include a surface coming in contact with air, liquid, etc. while including a flow passage groove to maximize the contact area.

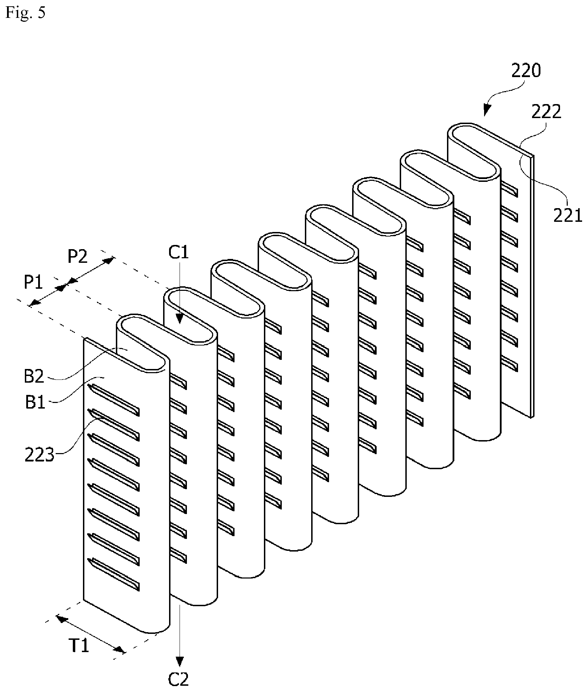

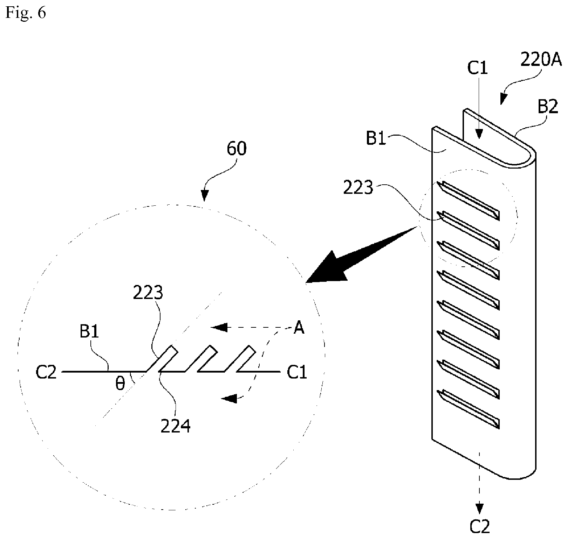

FIGS. 5 and 6 illustrate an embodiment of a structure of the thermoelectric conversion member 220 according to FIGS. 3 and 4.

As illustrated, in order to perform surface contact with air, the first thermoelectric conversion member 220 may be formed in a structure in which at least one flow passage pattern 220A forming an air flow passage C1 which is a predetermined transfer passage of air is implemented on flat-plate-shaped base materials including a first flat surface 221 and a second flat surface 222 which is the opposite surface of the first flat surface 221.

As illustrated in FIG 5 and FIG. 6, the base materials may be formed in a folding structure such that the flow passage pattern 220A is formed with a curvature pattern having predetermined pitches P1, P2 and height T1. That is, the thermoelectric conversion members 220 and 320 according to the embodiment of the present invention may have two flat surfaces coming in contact with air and may be implemented in a structure having a flow passage pattern formed to maximize the surface area coming in contact with air.

In the structure illustrated in FIG. 6, when air is introduced from a direction of the flow passage C1 at the inlet part from which the air is introduced, the air moves toward a direction of the end C2 of the flow passage while evenly coming in contact with the first flat surface 221 and the second flat surface 222 which is the opposite surface of the first flat surface 221. Thus, contact with a much larger amount of air may be induced in the same space compared to a contact surface with a simple flat plate shape, thereby further improving an effect of heat absorption or heat generation.

Particularly, to further increase the area coming in contact with air, the first thermoelectric conversion member 220 includes resistive patterns 223 on a surface of the base material as illustrated in FIG. 6. The resistive patterns 223 may be formed on each of a first curved surface B1 and a second curved surface B2 in consideration of a unit flow passage pattern. The resistive patterns 223 may be implemented in a structure in which each protrudes toward any one of the first flat surface 221 and the second flat surface 222 facing the first flat surface 221.

Furthermore, the thermoelectric conversion member 220 further includes a plurality of fluid flowing grooves 224 passing through the surfaces of the base materials, and air may more freely come in contact with and flow between the first flat surface and the second flat surface of the thermoelectric conversion member 220 via the plurality of fluid flowing grooves 224.

Particularly, as in the partially enlarged view in FIG. 6, the resistive pattern 223 is formed with a protruding structure tilted to have an inclined angle θ in a direction in which air enters in order to maximize friction with the air, thereby further improving the contact area or contact efficiency. The inclined angle θ is more preferably formed in a way that a horizontal extension line of the surface of the resistive pattern and an extension line of the surface of the base material form an acute angle since the effect of resistance decreases when the inclined angle θ is a right angle or an obtuse angle. Also, the fluid flowing grooves 224 may be arranged at connection parts of the resistive patterns and the base materials to simultaneously increase resistance of fluid such as air and improve efficiency of the air flowing toward the opposite surface. Specifically, the fluid flowing grooves 224 are formed on the base material surface at the front portion of the resistive patterns 223 to allow some of the air coming in contact with the resistive patterns 223 to pass through the front surface and the rear surface of the base materials, thereby further increasing the frequency or area of the contact.

Although the flow passage pattern illustrated in FIG. 6 is in a structure having a predetermined pitch and is formed to have a predetermined cycle, the pitch of the unit pattern need not be uniform, and the cycle of the pattern may also be non-uniform. Furthermore, the height T1 of each unit pattern may also be changed to be non-uniform.

Although a structure of the thermoelectric converter 10 according to the embodiment of the present invention in which one of the thermoelectric conversion members 220, 320, 520, and 620 are respectively included in the thermoelectric conversion modules 200, 300, 500, and 600 is illustrated in FIG. 4, the thermoelectric converter 10 may be implemented in a structure in which a plurality of thermoelectric conversion members are stacked within one thermoelectric conversion module in another embodiment. By this, a surface area coming in contact with air, etc. may be further maximized, and since several contact surfaces may be formed in a narrow area in the above structure due to the characteristic of the thermoelectric conversion member of the present invention formed in a folding structure, a larger number of thermoelectric conversion members may be arranged within the same volume. Of course, a support substrate such as a middle member may be further arranged between the thermoelectric conversion members stacked in this case. Furthermore, the thermoelectric converter 10 may also be implemented in a structure having two or more thermoelectric conversion modules in still another embodiment.

In addition, in the embodiment of the present invention, a pitch of the thermoelectric conversion member forming the heat generation part and a pitch of the thermoelectric conversion member forming the heat absorption part may be formed differently from each other. In this case, particularly, the pitch of the flow passage pattern of the thermoelectric conversion member within the thermoelectric conversion module forming the heat generation part may be formed greater than the pitch of the flow passage pattern of the thermoelectric conversion member within the thermoelectric conversion module forming the heat absorption part. In this case, a ratio between the width of the pitch of the flow passage pattern of the first thermoelectric conversion member 220 and the third thermoelectric conversion member 620 arranged in the cooling area 700 and the width of the pitch of the flow passage pattern of the second thermoelectric conversion member 320 and the fourth thermoelectric conversion member 520 arranged in the cooling area 700 may be any one ratio belonging to the range of 1:0.5 to 1:2.0. The cooling efficiency may be maximized within the above range, and air circulation may be hindered or heat transfer of the heat generation area that does not form the cooling area 700 may increase when the ratio deviates from the above range, thus degrading the cooling function.

In addition, since the structure of the thermoelectric conversion member according to the embodiment of the present invention is able to implement a considerably larger contact area within the same volume compared to the thermoelectric conversion member in a flat plate structure or a structure of conventional heat radiation fins, a 50% or more increase in the area coming in contact with air may be brought about compared to the thermoelectric conversion member in the flat plate structure, and accordingly, the size of the thermoelectric conversion module may also be considerably reduced. In addition, various materials including metal materials with high heat transfer efficiency such as aluminum and synthetic resin may be applied to the thermoelectric conversion member.

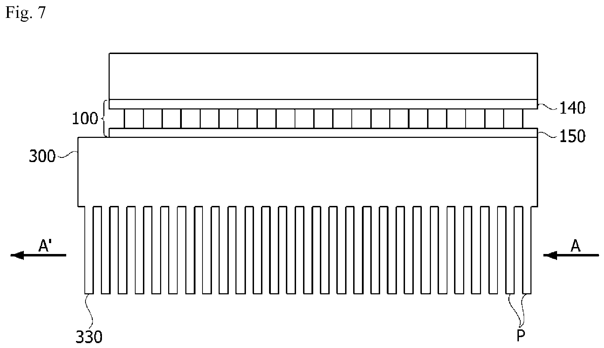

FIG. 7 illustrates an example of implementing the first thermoelectric conversion module 200, the second thermoelectric conversion module 300, the third thermoelectric conversion module 600, and the fourth thermoelectric conversion module 500 in a structure according to a different embodiment from the structure of the thermoelectric conversion member mentioned above with reference to FIG. 6. In the structure illustrated in FIG. 7, only the second thermoelectric conversion module 300 that comes in contact with the second substrate 150 to implement the cooling area 700 is illustrated, and the design of the thermoelectric conversion member may be changed to a fin structure 330 from the structure having curvatures. Of course, all of the thermoelectric conversion members 220, 320, 520, and 620 included in the above-mentioned first thermoelectric conversion module 200, second thermoelectric conversion module 300, third thermoelectric conversion module 600, and the fourth thermoelectric conversion module 500 may be implemented in the fin structure. Also, although not illustrated, the thermoelectric conversion members 220, 320, 520, and 620 applied to all of the embodiments of the present invention may also be implemented by combining the fin structure type and the type in which the flow passage pattern is implemented illustrated in FIG. 6.

In the case of the fin structure type thermoelectric conversion member illustrated in FIG. 7, a ratio between a fin pitch of a fin structure included in the first thermoelectric conversion member 220 and the third thermoelectric conversion member 620 arranged in the cooling area 700 and a fin pitch of a fin structure included in the second thermoelectric conversion member 320 and the fourth thermoelectric conversion member 520 may be any one of ratios belonging to the range of 1:0.5 to 1:2.0. Furthermore, in this case, the length of the fin in the fin structure may be implemented in a range of 3 mm to 100 mm. The cooling efficiency may be maximized within the above range, and air circulation may be hindered or heat transfer of the heat generation area that does not form the cooling area 700 may increase when the ratio deviates from the above range, thus degrading the cooling function.

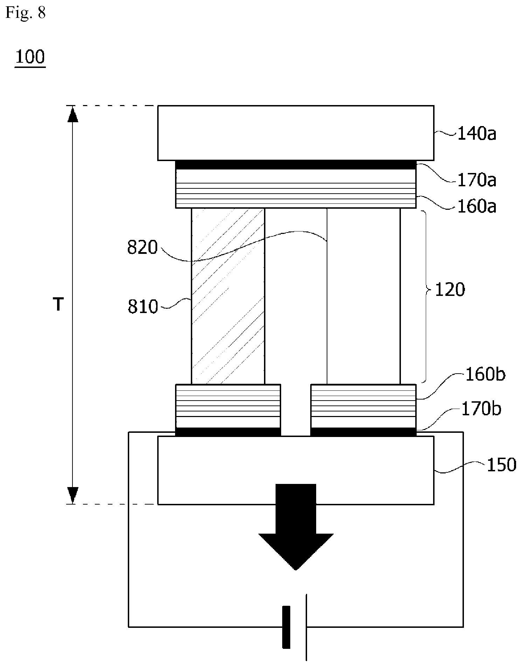

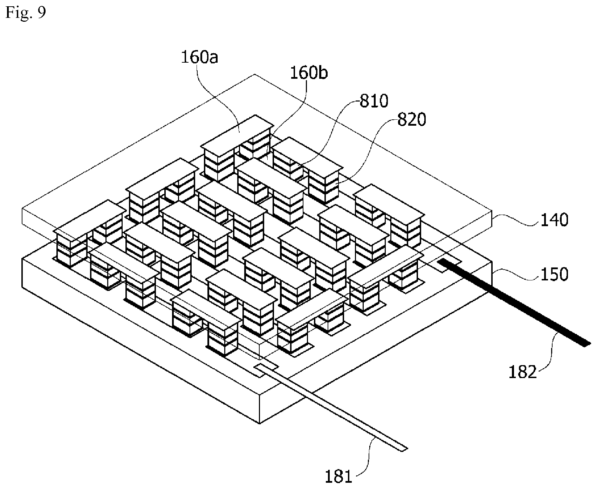

Hereinafter, a structure of the first thermoelectric module 100 applied to the thermoelectric converter 10 according to the embodiment of the present invention illustrated in FIG. 1 will be described in more detail with reference to FIGS. 8 and 9. Hereinafter, since structures of the first thermoelectric module 100 and the second thermoelectric module 400 are the same, description will be given with respect to the structure of the first thermoelectric module 100.

The thermoelectric module including a thermoelectric element according to the embodiment of the present invention may be formed in a structure including at least one unit cell that includes the first substrate 140 and the second substrate 150 facing each other, a first semiconductor element 810 and a second semiconductor element 820. The first semiconductor element 810 is positioned between the first substrate 140 and the second substrate 150, and the second semiconductor element 820 is located between the first substrate 140 and the second substrate 150 and electrically connected to the first semiconductor element 810. An insulating substrate such as an alumina substrate may be used for the first substrate 140 and the second substrate 150, or in the case of another embodiment, a metal substrate may be used for the first substrate 140 and the second substrate 150 for heat absorption, heat generation efficiency, and thinning the first substrate 140 and the second substrate 150. Of course, when the first substrate 140 and the second substrate 150 are formed with metal substrates, the thermoelectric module preferably further includes dielectric layers 170a and 170b respectively formed between the first substrate 140 and an electrode layer 160a and between the second substrate 150 and an electrode layer 160b as illustrated in FIG. 8. When the third substrate 440 and the fourth substrate 450 of the first thermoelectric conversion module 200 and the first substrate 140 and the second substrate 150 of the second thermoelectric conversion module 300, are implemented in an integral structure, materials such as alumina, Cu, and Cu alloys may be applied to the first substrate 140 and the second substrate 150.

In the case of the metal substrates, Cu or Cu alloys may be applied and the metal substrates may be thinned to be within a thickness range of 0.1 mm to 0.5 mm. Reliability of the thermoelectric module considerably decreases due to an excessively high heat radiation characteristic or extremely high thermal conductivity when the thickness of the metal substrates is thinner than 0.1 mm or thicker than 0.5 mm. Also, in the case of the dielectric layers 170a and 170b, a substance with thermal conductivity of 5-10W/K is used as a dielectric material having a high heat radiation performance in consideration of a thermal conductivity of the thermoelectric module for cooling, and the thickness of the dielectric layers 170a and 170b may be in a range of 0.01 mm to 0.15 mm. In this case, insulation efficiency (or voltage withstand characteristic) considerably decreases when the thickness is smaller than 0.01 mm, and thermal conductivity lowers and heat radiation efficiency decreases when the thickness exceeds 0.15 mm. The electrode layers 160a and 160b use electrode materials such as Cu, Ag, and Ni to electrically connect the first semiconductor element 810 and a second semiconductor element 820, and when a plurality of illustrated unit cells are connected, the unit cells are electrically connected to adjacent unit cells as illustrated in FIG. 3. The thickness of the electrode layers may be formed within the range of 0.01 mm to 0.3 mm. Performance as an electrode degrades and electrical conductivity becomes poor when the thickness of the electrode layers is smaller than 0.01 mm, and the conduction efficiency decreases due to an increase in resistance when the thickness exceeds 0.3 mm.

Particularly, in this case, the thermoelectric element forming a unit cell may include a unit element in a stacked structure according to the embodiment of the present invention. In this case, one side may be the first semiconductor element 810 which is a P-type semiconductor, and the other side may be the second semiconductor element 820 which is an N-type semiconductor. The first semiconductor element 810 and the second semiconductor element 820 are connected to the metal electrodes 160a and 160b, this structure is formed in plurality, and the Peltier effect is realized by circuit wires 181 and 182 through which current is supplied to the semiconductor elements via the electrodes.

A P-type semiconductor or an N-type semiconductor may be applied to the semiconductor element within the thermoelectric module. The N-type semiconductor material may be formed using a mixture in which a bismuth-telluride-base main material substance including selenium (Se), nickel (Ni), aluminum (Al), copper (Cu), silver (Ag), lead (Pb), boron (B), gallium (Ga), tellurium (Te), bismuth (Bi), and indium (In) are mixed with Bi or Te corresponding to 0.001-1.0 wt% of the overall weight of the main material substance. For example, the N-type semiconductor material may be formed having a Bi-Se-Te substance as the main material substance and adding Bi or Te corresponding to 0.001-1.0 wt% of the overall weight of Bi-Se-Te thereto. That is, when 100 g of Bi-Se-Te is injected, additionally mixed Bi or Te should be preferably in a range of 0.001 g to 1.0 g. As described above, when the range of the weight of the substance being added to the main material substance is not within the range of 0.001 wt% to 0.1 wt%, it is significant in that ZT value cannot be expected to be improved due to thermal conductivity not decreasing and electrical conductivity decreasing.

The P-type semiconductor material is preferably formed using a mixture in which a Bi-Te-base main material substance including stibium (Sb), Ni, Al, Cu, Ag, Pb, B, Ga, Te, Bi, and In are mixed with Bi or Te corresponding to 0.001-1.0 wt% of the overall weight of the main material substance. For example, the P-type semiconductor material may be formed having a Bi-Sb-Te substance as the main material substance and adding Bi or Te corresponding to 0.001-1.0 wt% of the overall weight of Bi-Sb-Te thereto. That is, when 100 g of Bi-Sb-Te is injected, additionally mixed Bi or Te should be in a range of 0.001 g to 1.0 g. When the range of the weight of the substance being added to the main material substance is not within the range of 0.001 wt% to 0.1 wt%, it is significant in that a ZT value cannot be expected to improved due to thermal conductivity not decreasing and electrical conductivity decreasing.

Although the shape and size of the first semiconductor element 810 and the second semiconductor element 820 forming the unit cell and facing each other are the same, in consideration of the fact that a difference between electrical conductivity characteristics of the P-type semiconductor element and the N-type semiconductor element acts as an element that degrades cooling efficiency, the volumes of the first semiconductor element 810 and the second semiconductor element 820 may be differently formed to improve cooling performance.

That is, the volumes of the semiconductor elements of the unit cell facing each other may be differently formed by differently forming overall shapes, widening a cross-sectional diameter of any one of the semiconductor elements having the same height, or differently forming the heights or the cross-sectional diameters of the semiconductor elements of the same shape. Particularly, the diameter of the N-type semiconductor element may be formed larger than that of the P-type semiconductor element to increase the volume of the N-type semiconductor element in order to improve thermoelectric efficiency.

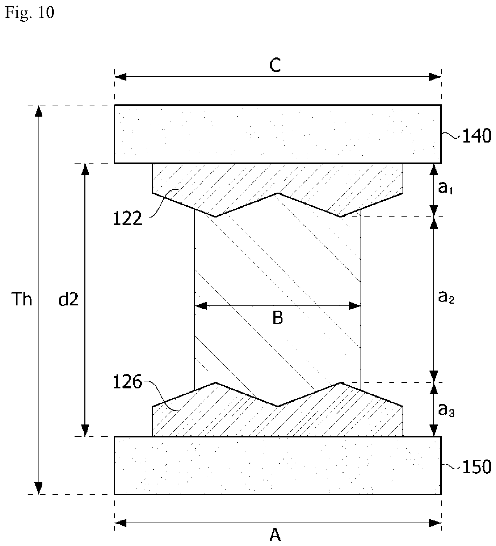

FIG. 10 illustrates a modified embodiment in which a shape of the thermoelectric element mentioned in FIG. 9 is changed.

Referring to FIGS. 9 and 10, the first thermoelectric element 120 according to another modified embodiment of the present invention may be implemented in a structure including a first element part 122 having a first cross-sectional area, a second element part 126 having a second cross-sectional area at a position facing the first element part 122, and a connection part 124 having a third cross-sectional area to connect the first element part 122 to the second element part 126. Particularly, in this case, a horizontal cross-sectional area at any region of the connection part 124 may be smaller than the first cross-sectional area and the second cross-sectional area.

This structure enables the areas of the first element part 122 and the second element part 126 to be widened and the length of the connection part 124 to be increased when the same amount of material as the thermoelectric element having the same material and having one cross-sectional area such as a cubic structure is applied, thereby having an advantage of being able to increase a temperature difference ΔT between the first element part and the second element part. When the temperature difference increases as above, the number of free electrons moving between a hot side and a cold side increases such that an amount of electricity being generated increases, thereby improving efficiency of heat generation or cooling.

Consequently, the first thermoelectric element 120 according to the embodiment widely forms horizontal cross-sectional areas of the first element part 122 and the second element part 126 formed in a flat plate structure or other three-dimensional structures at an upper portion and a lower portion of the connection part 124 and extends the length of the connection part 124 to narrow the cross-sectional area of the connection part. Particularly, in the embodiment of the present invention, a ratio between a width B of a cross-section having the longest width among horizontal cross-sections of the connection part 124 and a larger cross-sectional width A or C between horizontal cross-sectional areas of the first element part 122 and the second element part 126 should be in a range satisfying a range of 1:1.5 to 1:4. When the ratio deviates from this range, heat is conducted from the hot side to the cold side, thus actually decreasing generation efficiency or decreasing efficiency of heat generation or cooling.

In another aspect of the embodiment of this structure, in the first thermoelectric element 120, longitudinal thicknesses a1 and a3 of the first element part 122 and the second element part 126 may be formed smaller than the longitudinal thickness s2 of the connection part 124.

Furthermore, in this embodiment, the first cross-sectional area which is a horizontal cross-sectional area of the first element part 122 and the second cross-sectional area which is a horizontal cross-sectional area of the second element part 126 may be formed differently from each other. This is to easily adjust a temperature difference to a desired value by controlling the thermoelectric efficiency. In addition, the first element part 122, the second element part 126, and the connection part 124 may be integrally formed with each other, and in this case, each of the parts may be formed with the same material.

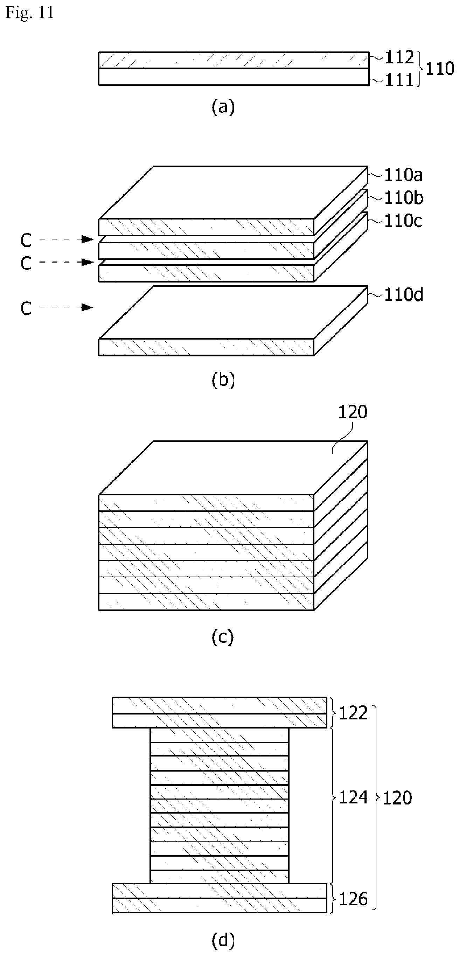

FIG. 11 illustrates an example of implementing a structure of the thermoelectric element according to the above-mentioned embodiment of the present invention using a different method and configurations.

Referring to FIG. 11, in still another embodiment of the present invention, the above-mentioned semiconductor elements may be implemented in a stacked structure instead of a bulk structure for thinning and further improving cooling efficiency. Specifically, the structures of the first semiconductor element 810 and the second semiconductor element 820 according to FIG. 9 or 10 may be formed with unit members formed by stacking a plurality of structures in which a semiconductor substance is applied on a sheet type base material and cutting the unit members to prevent loss of material and improve electrical conductivity characteristic.

With respect to this, referring to FIG. 11, FIG. 11 is a conceptual view illustrating a process of manufacturing the above-mentioned unit member in a stacked structure. According to FIG. 11, a material including a semiconductor material substance is fabricated in a paste form, and the paste is applied on a base material 111 such as a sheet and a film to form a semiconductor layer 112 in order to form one unit member 110. As illustrated in FIG. 11, a plurality of unit members 110a, 110b, and 110c are stacked to form a stacked structure, and then a unit thermoelectric element 120 cut from the stacked structure is formed. That is, the unit thermoelectric element 120 according to the present invention may be formed with a structure in which a plurality of unit members 110 formed by stacking the semiconductor layer 112 on the base material 111 are stacked.

In the above process, applying the paste on the base material 111 may be implemented using various methods. For example, the applying of the paste may be implemented using a tape casting process. The tape casting process is a process of manufacturing slurry by mixing extremely fine semiconductor material powder with aqueous or non-aqueous solvent, binder, plasticizer, dispersant, defoamer, and surfactant and forming the slurry with a uniform thickness according to purposes on a moving blade or a moving base material being carried. In this case, materials such as a film, sheet, etc. in a thickness range of 10 um to 100 um may be used as the base material, and of course, the P-type semiconductor material and the N-type semiconductor material for manufacturing the above-mentioned bulk type element may also be applied to the semiconductor material being applied.

The unit member 110 may be aligned and stacked in multiple layers and pressed at a temperature of 50-250 °C to form the stacked structure. A number of the unit member 110 being stacked may be in a range of 2-50. Then, a process of cutting the stacked structure in a desired form and size may be performed, and a sintering process may be added.

Uniformity of thickness and size of shape may be achieved in the unit thermoelectric element formed by stacking a plurality of unit members 110 manufactured according to the above-mentioned process. That is, although a large amount of materials are lost in a cutting process, cutting into uniform sizes is difficult, and thinning is difficult due to the thickness of 3 mm to 5 mm in terms of the conventional bulk type thermoelectric element since a sintered bulk structure is cut after ingot grinding and a refining ball-mill process, almost no material is lost, uniformity of materials may be achieved due to the materials having a uniform thickness, the overall thickness of the unit thermoelectric element may be thinned to 1.5 mm or smaller, and various shapes may be applied in terms of the unit thermoelectric element in a stacked structure according to the embodiment of the present invention since a sheet-stacked structure is cut after stacking sheet-type unit members in multiple layers. A finally implemented structure may be implemented by cutting the stacked structure in a shape illustrated in (d) of FIG. 11 as in the structure of FIG. 9 or the structure of the thermoelectric element according to the embodiment of the present invention illustrated in FIG. 10. This structure may be applied to the first thermoelectric module or the second thermoelectric module of the thermoelectric converter illustrated in FIG. 1 as an independent structure or a combined structure.

Particularly, in the process of manufacturing the unit thermoelectric element according to the embodiment of the present invention, the process of forming the stacked structure by stacking a plurality of unit members 110 may further include forming a conductive layer on a surface of each unit member 110.

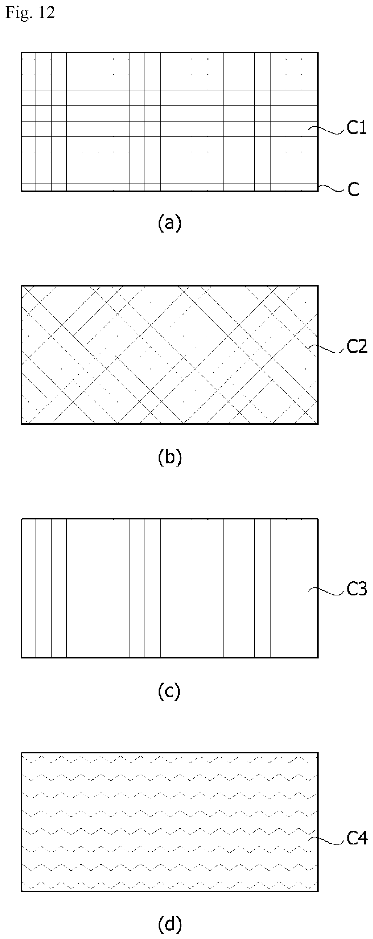

That is, conductive layers illustrated in FIG. 12 may be formed between unit members of the stacked structure in (c) of FIG. 11. The conductive layers may be formed on opposite surfaces of base material surfaces on which the semiconductor layers 112 are formed, and in this case, the conductive layers may be formed with patterned layers to form regions from which surfaces of the unit members are exposed. Electrical conductivity may be improved compared to when the conductive layers are fully applied on the surfaces of the unit members and a binding force between each of the unit members may be improved at the same time, thereby having an advantage of lowering thermal conductivity.

In other words, FIG. 12 illustrates various modified embodiments of a conductive layer C according to the embodiment of the present invention. The pattern in which the surfaces of the unit members are exposed may be modified and designed in various ways such as a mesh type structure including closed type open patterns C1 and C2 as illustrated in (a) and (b) of FIG. 12 or a line type structure including opened type open patterns C3 and C4 as illustrated in (c) and (d) of FIG. 12. The above conductive layers not only improve the binding force between each of the unit members within the unit thermoelectric element formed in a stacking structure of a plurality of unit members, but also lowers thermal conductivity between each of the unit members, thus having an advantage of improving electrical conductivity. Also, a cooling quantity Qc and ΔT (°C) are improved compared to the conventional bulk type thermoelectric element, and particularly, a power factor, i.e. electrical conductivity, increases by 1.5. Since the increase in the electrical conductivity is directly related to an improvement in thermoelectric efficiency, the cooling efficiency is enhanced. The conductive layers may be formed with metal materials, and all of metallic electrode materials such as Cu, Ag, and Ni may be applied to the conductive layers.

When the unit thermoelectric element in the stacked structure illustrated in FIG. 11 is applied to the thermoelectric modules illustrated in FIGS. 1 and 2, i.e. when the thermoelectric element according to the embodiment of the present invention is disposed between the first substrate 140 and the second substrate 150 and the thermoelectric modules are implemented using the unit cells formed in the structure including the electrode layers and the dielectric layers, the overall thickness Th may be formed in a range of 1 mm to 1.5 mm, thereby making the thermoelectric modules considerably thinner compared to using the conventional bulk type element.

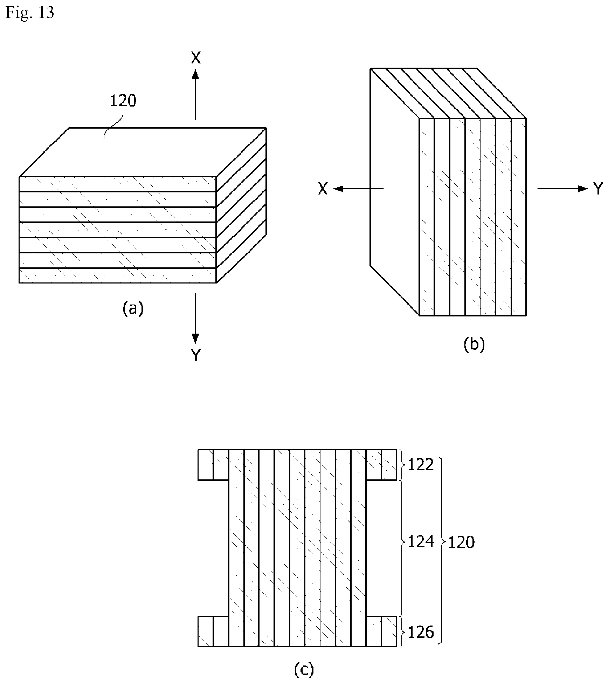

In addition, as illustrated in FIG. 13, the thermoelectric elements 120 and 130 illustrated in FIG. 10 may be aligned to be horizontally arranged in a lower direction Y as illustrated in (a) of FIG. 13 and cut as in (c) of FIG. 13 to implement the thermoelectric elements according to the embodiment of the present invention.

That is, although the thermoelectric modules may be formed in a structure in which the first substrate 140, the second substrate 150, the semiconductor layers 112, and the base material surfaces are arranged to be adjacent to each other, the thermoelectric elements themselves may be vertical as illustrated in (b) of FIG. 13 to allow side surface portions of the unit thermoelectric elements to be disposed adjacent to the first and second substrates. In this structure, end portions of the conductive layers are more exposed to the side surface portions than in the horizontally arranged structure, thereby simultaneously lowering thermal conduction efficiency in the vertical direction and further improving cooling efficiency due to being able to improve the electrical conduction characteristic. Furthermore, the shape in FIG. 10 may be implemented and applied by cutting as illustrated in FIG. 13.

As described above, in the thermoelectric elements applied to the thermoelectric modules of the present invention that may be implemented in various embodiments, although the shape and size of the first semiconductor element 810 and the second semiconductor element 820 facing each other are the same, in consideration of the fact that a difference between electrical conductivity characteristics of the P-type semiconductor element and the N-type semiconductor element acts as an element that degrades cooling efficiency in this case, the volumes of the first semiconductor element 810 and the second semiconductor element 820 may be differently formed to improve a cooling performance.

That is, the volumes of the semiconductor elements facing each other may be differently formed by differently forming overall shapes, widening a cross-sectional diameter of any one of the semiconductor elements having the same height, or differently forming the heights or the cross-sectional diameters of the semiconductor elements of the same shape. Particularly, the diameter of the N-type semiconductor element may be formed larger than that of the P-type semiconductor element to increase the volume of the N-type semiconductor element in order to improve thermoelectric efficiency.

The thermoelectric elements formed in various structures and the thermoelectric modules including the same according to the above-mentioned embodiment of the present invention can be applied to a dehumidifier to maximize dehumidification efficiency.

According to an embodiment of the present invention, a thermoelectric converter implementing a structure in which two or more thermoelectric modules are stacked and cooling areas of the stacked thermoelectric modules are arranged in a compact structure to maximize cooling efficiency can be provided.

Particularly, when the thermoelectric converter according to the embodiment of the present invention is applied to implement a dehumidifier, a compressor of a conventional compressor structure can be removed and a dehumidifier can be implemented with only thermoelectric conversion modules that does not use chemical refrigerant at all.

## Claims

1. A thermoelectric converter(10) comprising:
a first thermoelectric module(100) comprising a first substrate(140), a second substrate(150) disposed to face the first substrate(140), and a first thermoelectric element(120) disposed between the first substrate(140) and the second substrate(150);
a first thermoelectric conversion member(220) disposed on the first substrate(140);
a second thermoelectric conversion meniber(320) disposed on the second substrate(150);
a second thermoelectric module(400) comprising a third substrate(440), a fourth substrate(450) disposed to face the third substrate(440), and a second thermoelectric element(420) disposed between the third substrate(440) and the fourth substrate(450);
a third thermoelectric conversion member(620) disposed on the third substrate(440); and
a fourth thermoelectric conversion member(520) disposed on the fourth substrate(450), wherein:
the first substrate(140) and the third substrate(440) are heat generation substrates;
the second substrate(150) and the fourth substrate(450) are heat absorption substrates; and
the first thermoelectric module(100) and the second thermoelectric module(400) are arranged in a structure in which the second substrate(150) and the fourth substrate(450) face each other,
wherein the first thermoelectric conversion member(220), the second thermoelectric conversion member(320), the third thermoelectric conversion member(620), and the fourth thermoelectric conversion member(520) comprise a plurality of fin structures,
wherein at least one of the first thermoelectric conversion member(220), the second thermoelectric conversion member(320), the third thermoelectric conversion member(620), and the fourth thermoelectric conversion member(520) comprises:
a heat generation base material having a first flat surface coming in contact with air and a second flat surface facing the first flat surface;
at least one flow passage pattern(220A) structure configured to form an air flow passage(C1) within the heat generation base material in an air flowing direction;
a plurality of fluid flowing grooves(224) passing through the surfaces of the flow passage pattern(220A) **characterised by** a plurality of resistive pattern(223) protruding from a surface of the heat generation base material on a surface of the flow passage pattern(220A),
wherein the fluid flowing grooves(224) is arranged at connection parts of the resistive pattern(223) and the flow passage pattern(220A),
wherein the resistive pattern(223) is formed with a protruding structure tilted to have an inclined angle (θ) in a direction in which the air enters,
wherein the inclined angle(θ) is formed in a way that a horizontal extension line of the surface of the resistive pattern(223) and an extension line of the surface of the flow passage pattern(220A) form an acute angle.

2. The thermoelectric converter(10) according to claim 1, wherein the first thermoelectric module(100) and the second thermoelectric module(400) are arranged such that the second thermoelectric conversion member(320) and the fourth thermoelectric conversion member(520) come in contact with each other.

3. The thermoelectric converter(10) according to claim 1, wherein a ratio between a fin pitch of a fin structure included in the first thermoelectric conversion member(220) and the third thermoelectric conversion member(620) and a fin pitch of a fin structure included in the second thermoelectric conversion member(320) and the fourth thermoelectric conversion member(520) is any one of ratios belonging to the range of 1:0.5 to 1:2.0.

4. The thermoelectric converter(10) according to claim 3, wherein the length of the fin in the fin structure is any one belonging to a range of 3 mm to 100 mm.

5. The thermoelectric converter(10) according to claim 1, wherein the flow passage pattern(220A) is a structure comprising a curvature pattern having a uniform pitch in a longitudinal direction of the heat generation base material.

6. The thermoelectric converter(10) according to claim 1, wherein a ratio between a width of a pitch of a flow passage pattern(220A) included in the first thermoelectric conversion member(220) and the third thermoelectric conversion member(620) and a width of a pitch of a flow passage pattern(220A) included in the second thermoelectric conversion member(320) and the fourth thermoelectric conversion member(620) is any one ratio belonging to the range of 1:0.5 to 1:2.0.

7. The thermoelectric converter(10) according to any one of claims 1 to 6 , further comprising an air circulation module configured to introduce outside air into the thermoelectric converter and circulate the air.

8. A dehumidifier comprising the thermoelectric converter(10) according to claim 7.

## Patentansprüche

1. Thermoelektrischer Wandler (10) umfassend:
ein erstes thermoelektrisches Modul (100) umfassend ein erstes Substrat (140), ein dem ersten Substrat (140) zugewandt angeordnetes zweites Substrat (150), und ein erstes thermoelektrisches Element (120), das zwischen dem ersten Substrat (140) und dem zweiten Substrat (150) angeordnet ist;
ein erstes thermoelektrisches Umwandlungselement (220), das an dem ersten Substrat (140) angeordnet ist;
ein zweites thermoelektrisches Umwandlungselement (320), das an dem zweiten Substrat (150) angeordnet ist;
ein zweites thermoelektrisches Modul (400) umfassend ein drittes Substrat (440), ein dem dritten Substrat (440) zugewandt angeordnetes viertes Substrat (450), und ein zweites thermoelektrisches Element (420), das zwischen dem dritten Substrat (440) und dem vierten Substrat (450) angeordnet ist;
ein drittes thermoelektrisches Umwandlungselement (620), das an dem dritten Substrat (440) angeordnet ist; und
ein viertes thermoelektrisches Umwandlungselement (520), das an dem vierten Substrat (450) angeordnet ist; wobei:
das erste Substrat (140) und das dritte Substrat (440) Wärmeerzeugungssubstrate sind;
das zweite Substrat (150) und das vierte Substrat (450) Wärmeabsorptionssubstrate sind; und
das erste thermoelektrische Modul (100) und das zweite thermoelektrische Modul (400) in einer Struktur angeordnet sind, in der das zweite Substrat (150) und das vierte Substrat (450) einander zugewandt sind,
wobei das erste thermoelektrische Umwandlungselement (220), das zweite thermoelektrische Umwandlungselement (320), das dritte thermoelektrische Umwandlungselement (620) und das vierte thermoelektrische Umwandlungselement (520) eine Vielzahl von Rippenstrukturen umfassen,
wobei wenigstens eines des ersten thermoelektrischen Umwandlungselements (220), des zweiten thermoelektrischen Umwandlungselements (320), des dritten thermoelektrischen Umwandlungselements (620) und des vierten thermoelektrischen Umwandlungselements (520) umfasst:
ein Wärmeerzeugungsbasismaterial, das eine erste flache Oberfläche, die in Kontakt mit Luft kommt, und eine der ersten flachen Oberfläche zugewandte zweite flache Oberfläche aufweist;
wenigstens eine erste Strömungsdurchgangsmuster (220A)-Struktur, die dazu konfiguriert ist, einen Luftströmungsdurchgang (C1) innerhalb des Wärmeerzeugungsbasismaterials in einer Luftströmungsrichtung zu bilden;
eine Vielzahl von Fluidströmungsnuten (224), die durch die Oberflächen des Strömungsdurchgangsmusters (220A) hindurchgehen,
**gekennzeichnet durch**
eine Vielzahl von Widerstandsmustern (223), die von einer Oberfläche des Wärmeerzeugungsbasismaterials an einer Oberfläche des Strömungsdurchgangsmusters (220A) vorstehen,
wobei die Fluidströmungsnuten (224) an Verbindungsteilen des Widerstandsmusters (223) und des Strömungsdurchgangsmusters (220A) angeordnet sind,
wobei das Widerstandsmuster (223) mit einer vorstehenden Struktur gebildet ist, die so geneigt ist, dass sie einen Neigungswinkel (θ) in einer Richtung aufweist, in der die Luft eintritt,
wobei der Neigungswinkel (θ) derart gebildet ist, dass eine horizontale Verlängerungslinie der Oberfläche des Widerstandsmusters (223) und eine Verlängerungslinie der Oberfläche des Strömungsdurchgangsmusters (220A) einen spitzen Winkel bilden.

2. Thermoelektrischer Wandler (10) nach Anspruch 1, wobei das erste thermoelektrische Modul (100) und das zweite thermoelektrische Modul (400) derart angeordnet sind, dass das zweite thermoelektrische Umwandlungselement (320) und das vierte thermoelektrische Umwandlungselement (520) in Kontakt miteinander kommen.

3. Thermoelektrischer Wandler (10) nach Anspruch 1, wobei ein Verhältnis zwischen einem Rippenabstand einer Rippenstruktur, die in dem ersten thermoelektrischen Umwandlungselement (220) und dem dritten thermoelektrischen Umwandlungselement (620) umfasst ist, und einem Rippenabstand einer Rippenstruktur, die in dem zweiten thermoelektrischen Umwandlungselement (320) und dem vierten thermoelektrischen Umwandlungselement (520) umfasst ist, irgendeines von Verhältnissen ist, die zu der Spanne von 1:0,5 bis 1:2,0 gehören.

4. Thermoelektrischer Wandler (10) nach Anspruch 3, wobei die Länge der Rippe in der Rippenstruktur irgendeine ist, die zu einer Spanne von 3 mm bis 100 mm gehört.

5. Thermoelektrischer Wandler (10) nach Anspruch 1, wobei das Strömungsdurchgangsmuster (220A) eine Struktur ist, die ein Krümmungsmuster umfasst, das einen gleichmäßigen Abstand in Längsrichtung des Wärmeerzeugungsbasismaterials aufweist.

6. Thermoelektrischer Wandler (10) nach Anspruch 1, wobei ein Verhältnis zwischen einer Breite eines Abstands eines Strömungsdurchgangsmusters (220A), das in dem ersten thermoelektrischen Umwandlungselement (220) und dem dritten thermoelektrischen Umwandlungselement (620) umfasst ist, und einer Breite eines Abstands eines Strömungsdurchgangsmusters (220A), das in dem zweiten thermoelektrischen Umwandlungselement (320) und dem vierten thermoelektrischen Umwandlungselement (520) umfasst ist, irgendein Verhältnis ist, das zu der Spanne von 1:0,5 bis 1:2,0 gehört.

7. Thermoelektrischer Wandler (10) nach einem der Ansprüche 1 bis 6, ferner umfassend ein Luftzirkulationsmodul, das dazu konfiguriert ist, Außenluft in den thermoelektrischen Wandler einzuführen und die Luft zu zirkulieren.

8. Entfeuchter umfassend den thermoelektrischen Wandler (10) nach Anspruch 7.

## Revendications

1. Un convertisseur thermoélectrique (10) comprenant :
un premier module thermoélectrique (100) comprenant un premier substrat (140), un deuxième substrat (150) disposé de façon à être tourné vers le premier substrat (140), et un premier élément thermoélectrique (120) disposé entre le premier substrat (140) et le deuxième substrat (150) ;
un premier organe de conversion thermoélectrique (220) disposé sur le premier substrat (140);
un deuxième organe de conversion thermoélectrique (320) disposé sur le deuxième substrat (150);
un deuxième module thermoélectrique (400) comprenant un troisième substrat (440), un quatrième substrat (450) disposé de façon à être tourné vers le troisième substrat (440), et un deuxième élément thermoélectrique (420) disposé entre le troisième substrat (440) et le quatrième substrat (450) ;
un troisième organe de conversion thermoélectrique (620) disposé sur le troisième substrat (440); et
un quatrième organe de conversion thermoélectrique (520) disposé sur le quatrième substrat (450), dans lequel :
le premier substrat (140) et le troisième substrat (440) sont des substrats de génération de chaleur ;
le deuxième substrat (150) et le quatrième substrat (450) sont des substrats d'absorption de chaleur; et
le premier module thermoélectrique (100) et le deuxième module thermoélectrique (400) sont disposés dans une structure dans laquelle le deuxième substrat (150) et le quatrième substrat (450) sont tournés l'un vers l'autre,
le premier organe de conversion thermoélectrique (220), le deuxième organe de conversion thermoélectrique (320), le troisième organe de conversion thermoélectrique (620), et le quatrième organe de conversion thermoélectrique (520) comprenant une pluralité de structures à ailettes,
au moins l'un parmi le premier organe de conversion thermoélectrique (220), le deuxième organe de conversion thermoélectrique (320), le troisième organe de conversion thermoélectrique (620) et le quatrième organe de conversion thermoélectrique (520) comprenant :
un matériau de base de génération de chaleur ayant une première surface plate venant en contact avec l'air et une deuxième surface plate tournée vers la première surface plate;
au moins une structure formant un motif (220A) de passage d'écoulement configurée pour former un passage d'écoulement d'air (C1) à l'intérieur du matériau de base de génération de chaleur dans une direction d'écoulement d'air;
une pluralité de rainures (224) d'écoulement de fluide passant à travers les surfaces du motif (220A) de passage d'écoulement, **caractérisé par**
une pluralité de motifs résistifs (223) faisant saillie d'une surface du matériau de base de génération de chaleur sur une surface du motif de passage d'écoulement (220A),
les rainures d'écoulement de fluide (224) étant agencées au niveau de parties de connexion du motif résistif (223) et du motif de passage d'écoulement (220A),
le motif résistif (223) étant formé avec une structure saillante inclinée de façon à avoir un angle incliné (θ) dans une direction dans laquelle l'air pénètre,
l'angle incliné (θ) étant formé de sorte qu'une ligne d'extension horizontale de la surface du motif résistif (223) et une ligne d'extension de la surface du motif (220A) de passage d'écoulement forment un angle aigu.

2. Le convertisseur thermoélectrique (10) selon la revendication 1, dans lequel le premier module thermoélectrique (100) et le deuxième module thermoélectrique (400) sont agencés de sorte que le deuxième organe de conversion thermoélectrique (320) et le quatrième organe de conversion thermoélectrique (520) entrent en contact l'un avec l'autre.

3. Le convertisseur thermoélectrique (10) selon la revendication 1, dans lequel un rapport entre un pas d'ailette d'une structure à ailettes incluse dans le premier organe de conversion thermoélectrique (220) et le troisième organe de conversion thermoélectrique (620) et un pas d'ailette d'une structure à ailettes incluse dans le deuxième organe de conversion thermoélectrique (320) et le quatrième organe de conversion thermoélectrique (520) est l'un quelconque des rapports appartenant à la plage allant de 1:0,5 à 1:2,0.

4. Le convertisseur thermoélectrique (10) selon la revendication 3, dans lequel la longueur de l'ailette dans la structure à ailettes est l'une quelconque des longueurs appartenant à une plage allant de 3 mm à 100 mm.

5. Le convertisseur thermoélectrique (10) selon la revendication 1, dans lequel le motif (220A) de passage d'écoulement est une structure comprenant un motif de courbure ayant un pas uniforme dans une direction longitudinale du matériau de base de génération de chaleur.

6. Le convertisseur thermoélectrique (10) selon la revendication 1, dans lequel un rapport entre une largeur d'un pas d'un motif (220A) de passage d'écoulement inclus dans le premier organe de conversion thermoélectrique (220) et le troisième organe de conversion thermoélectrique (620) et une largeur d'un pas d'un motif (220A) de passage d'écoulement inclus dans le deuxième organe de conversion thermoélectrique (320) et le quatrième organe de conversion thermoélectrique (620) est un rapport quelconque appartenant à la plage de rapports allant de de 1:0,5 à 1:2,0.

7. Le convertisseur thermoélectrique (10) selon l'une quelconque des revendications 1 à 6, comprenant en outre un module de circulation d'air configuré pour introduire de l'air extérieur dans le convertisseur thermoélectrique et pour faire circuler l'air.

8. Un déshumidificateur comprenant le convertisseur thermoélectrique (10) selon la revendication 7.
